# EUROPEAN PATENT APPLICATION

(11) **EP 2 385 551 A1**
(43) Date of publication of application: **09.11.2011**
(21) Application number: 10305485.4
(22) Date of filing: 07.05.2010
(51) Int. Cl.: H01L 23/544

(54) **Silicon substrate wafer and test method**

(71) Applicant: IPDIA, 14000 Caen (FR)
(72) Inventor: Aumaille, Karine, 14000, CAEN (FR); Dupont, Annie, 14000, CAEN (FR); Jacqueline, Sébastien, 14000, CAEN (FR)
(74) Representative: Cabinet Plasseraud

(57) **Abstract**

A silicon substrate wafer (10) is disclosed comprising a plurality of through silicon vias (20, 30), each via being separated from the silicon substrate by a barrier layer (24, 34); and a test arrangement comprising a first contact pad (26) on a first surface of the wafer (10), said first contact pad being electrically connected to one of said vias (20); and a second contact pad (16) on the first surface, said second contact pad being electrically connected to a wafer portion, said portion being electrically insulated from the via (20) connected to the first contact pad (26) in case the barrier layer of said via (20) is intact. In a preferred embodiment, some of the through silicon vias (20a-20d) are dedicated test structures electrically interconnected at the backside of the wafer (10) by a conductive interconnect structure (50). A method for testing such a wafer (10) is also disclosed.

## Description

### FIELD OF THE INVENTION

The present invention relates to a silicon substrate wafer comprising a plurality of vias extending from a first surface to a second surface opposite to the first surface of the wafer, each via being separated from the silicon substrate by a barrier layer.

The present invention further relates to a method of testing such a wafer.

### BACKGROUND OF THE INVENTION

In the field of semiconductor technology, the ongoing demand for devices being capable of providing a plethora of different functions means that it is becoming increasingly difficult to provide a single die that implements all these functions. This has led to the development of multi-die devices such as multi-chip modules and system-in-package (SiP) devices, in which multiple dies are integrated, such that the required functionality may be distributed over the multiple dies. In order for these dies to be operable as a single device, these dies must be interconnected in some way.

For instance, in a SiP, the multiple dies may be mounted on both sides of a silicon substrate wafer, with the wafer comprising electrical connections both on the wafer surfaces as well as through the wafer. Such through connections are commonly known as through-silicon-vias (TSVs), because conceptually, these through connections resemble the via structures used in single dies to interconnect conductive structures in different layers of the die.

However, the manufacturing process of a TSV is typically substantially different to the manufacture of a 'classic' via because of the fact that the depth of a TSV is much larger, i.e. often well in excess of 100 micron. Consequently, a TSV has a much larger aspect ratio than a classic via, which means that in general, techniques that may be useful for the manufacture of a classic via are completely unsuitable for manufacturing a TSV.

One of the problems associated with metal plugs such as a copper plug in a via such as a TSV is that care has to be taken that the metal particles do not migrate into the silicon, e.g. during exposure to electrical currents or during exposure of the TSV to elevated temperatures, such as in the back-end manufacturing process of the wafer, because this would increase the risk of the formation of parasitic conductive paths, such as between two vias that should be electrically insulated from each other. To this end, prior to the formation of the metal core of the TSV, the TSV hole may be lined with a barrier layer to prevent the migration of the metal particles into the silicon.

Due to the large depth and high aspect ratio of the TSV, the formation of a conformal barrier layer is not trivial, and imperfections in the barrier layer integrity, e.g. cracks or exposed silicon areas, can still lead to the formation of parasitic conductive paths in the silicon substrate through these imperfections. For this reason, it is necessary to test the integrity of the barrier layer.

US 6,531,777 B1 discloses a method of testing the integrity of a barrier layer of a classic via. The barrier layer of a copper via is tested by electrically stressing electrically insulated copper features on different metal levels of the integrated circuit (IC) under test. However, this solution is unsuitable for testing the barrier layer integrity of a TSV due to the fact that the TSV extends through the whole wafer.

Instead, in the TSV domain, destructive tests are commonly used to examine the quality of the barrier layer obtained in a TSV manufacturing process. An example of such a test comprises the exposure of the wafer to a HF etching step after barrier layer deposition to expose the barrier layer followed by an inspection using SEM or TEM analysis. However, such tests have the drawback that silicon substrate wafers comprising conformal barrier layers may be destroyed, and that faulty silicon substrate wafers may not be detected because not every wafer can be investigated.

### SUMMARY OF THE INVENTION

The present invention seeks to provide a wafer according to the opening paragraph for which the barrier layer of the TSV may be electrically tested.

The present invention further seeks to provide a test method for testing the integrity of the barrier layer of the TSVs of such a wafer.

According to an aspect of the present invention, there is provided silicon substrate wafer comprising a plurality of vias extending from a first surface to a second surface opposite to the first surface of the wafer, each via being separated from the silicon substrate by a barrier layer; and a test arrangement comprising a first contact pad on the first surface, said first contact pad being electrically connected to one of said vias; and a second contact pad on the first surface, said second contact pad being electrically connected to a wafer portion, said portion being electrically insulated from the via connected to the first contact pad in case the barrier layer of said via is intact.

The present invention is based on the realization that the integrity of the barrier layer of a TSV may be tested by the integration of a test arrangement on one of the surfaces of the silicon substrate wafer such that the barrier layer integrity may be tested over the surface of the wafer carrying the test arrangement. In case of the presence of a parasitic conductive path through the barrier layer of the TSV under test, a non-negligible current or voltage drop may be detected between the first and second contact pads, thus indicating that the barrier layer integrity has been compromised. The portion may be a portion of the silicon substrate, a conductive structure such as a metal track not connected to the TSV under test or another TSV not connected to the TSV under test.

At this point, it is emphasized the skilled person would not consider the teachings of US 6,531,777 B1, because the solutions in the classic via domain are typically unsuitable for application in the TSV domain. And even if the skilled person would consider this document, it actually teaches away from the present invention because this document teaches that testing two electrically insulated vias over the surface of a wafer by contacting both vias and electrically stressing these vias is unreliable due to the fact that the chemical mechanical polishing (CMP) step required to remove excess copper from the silicon substrate can cause the migration of residual copper particles over the silicon substrate surface, thus forming parasitic conductive paths on the surface such that the barrier layer integrity cannot be accurately tested. However, an important insight of the present invention is that because planarization steps are not required following the formation of the metal core of a TSV, such parasitic conductive paths are typically not present on the surface of the silicon substrate wafer of the present invention.

In an embodiment, some of the vias are electrically connected through a further conductive structure on the second surface of the wafer, which preferably both are dedicated test structures. This has the advantage that the sensitivity of a barrier layer test is improved due to the fact that all interconnected vias may be tested simultaneously, thus increasing the effective barrier layer area under test.

According to a further aspect of the present invention, there is provided a method of testing the silicon substrate wafer of the present invention, the method comprising providing an electrical measuring device; establishing respective conductive contacts between the electrical measuring device and the first contact pad and a first further contact pad; and measuring an electrical parameter indicative of the integrity of the barrier layer with said measuring device.

The first further contact may be the second contact pad or the third contact pad, and the electrical parameter may be a current or voltage drop between the contacted contact pads. This allows for a non-destructive test of the barrier layer integrity of the TSV under test.

The method may further comprise establishing respective conductive contacts between the electrical measuring device and the first contact pad and a second further contact pad; and measuring an electrical parameter indicative of the integrity of the barrier layer with said measuring device. For instance, a first test may comprise contacting the first and second contact pads and the second test may comprise contacting the first and third contact pads or vice versa. This has the advantage that more detailed information about the barrier layer integrity may be obtained.

### BRIEF DESCRIPTION OF THE EMBODIMENTS

Embodiments of the invention are described in more detail and by way of non-limiting examples with reference to the accompanying drawings, wherein:
Fig. 1 schematically depicts a top view of an embodiment of a silicon substrate wafer of the present invention;
Fig. 2 schematically depicts a cross section of an embodiment of a silicon substrate wafer of the present invention; and
Fig. 3 schematically depicts a through view of another embodiment of a silicon substrate wafer of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

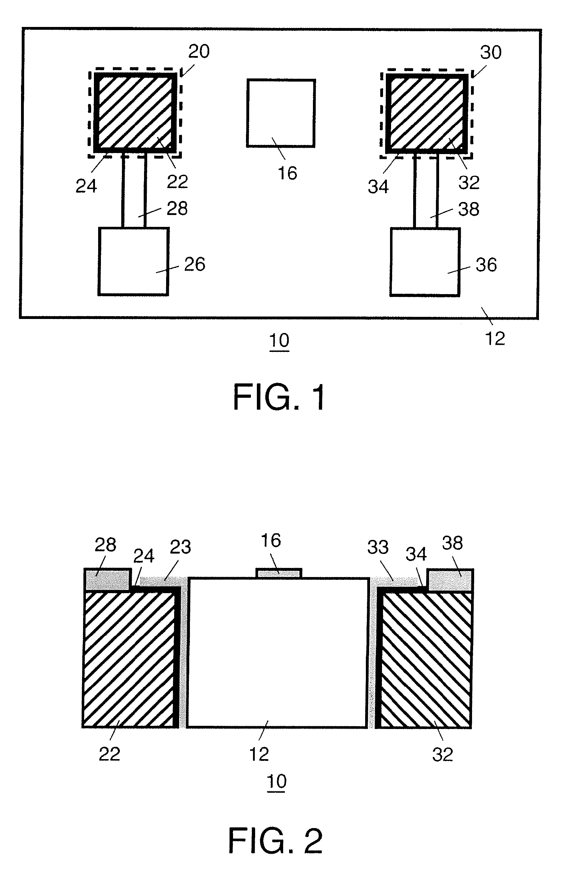

Fig. 1 depicts a top view of a part of a silicon substrate wafer 10 in accordance with an embodiment of the present invention. The silicon substrate 12 comprises a first TSV 20 and a second TSV 30, which are electrically insulated from each other by the silicon substrate 12. The TSV 20 has a metal core 22, e.g. a copper core surrounded by a barrier layer 24 to prevent diffusion of the metal into the silicon substrate 12. Similarly, the TSV 30 has a metal core 32, e.g. a copper core surrounded by a barrier layer 34 to prevent diffusion of the metal into the silicon substrate 12. The TSV 20 is electrically connected to a contact pad 26 via a conductive track 28 and the TSV 30 is electrically connected to a contact pad 36 via a conductive track 38. A further contact pad 16 mounted on the surface of the silicon substrate 12 is electrically connected to this substrate.

Fig. 2 depicts a cross section of this embodiment of the silicon substrate wafer 10. In Fig. 2, an optional insulating layer 23 for TSV 20 and an optional insulating layer 33 for TSV 30 are also shown. These layers may be dielectric layers, e.g. SiO₂ layers for electrically insulating the TSVs 20 and 30 from the silicon substrate 12. The TSVs 20 and 30 may be formed in any suitable way. The formation of such TSVs is known per se, and not essential to the present invention. For this reason, the formation of these TSVs is not discussed in great detail. It should be appreciated that any suitable material for the barrier layers and the conductive cores of the TSVs may be considered. It should also be appreciated that two TSVs are shown by way of non-limiting example only. The wafer 10 may comprise any number of TSVs.

It should further be understood that the provision of contact pads on a substrate surface is also well-known to the skilled person, such that a further description of the formation of the bond pads 16, 26 and 36 has been omitted for the sake of brevity only.

As previously explained, the barrier layers 24 and 34 typically should be conformal barrier layers in order to ensure that the conductive, e.g. metal, cores 22 and 32 can be formed without defects, e.g. cavities, therein. The barrier layers are typically very thin, e.g. in the range of 5-50 nm, which means that small deviations from the conformity of these layers can cause exposure of the conductive core of the TSV, e.g. core 22 of TSV 20, to the dielectric layer 23 (if present) or to the silicon substrate 12. This exposure can lead to the migration (e.g. diffusion) of metal particles from the conductive core 22 to the dielectric layer 23 and/or the substrate 12 when the conductive core 22 for instance is exposed to an electrical current or to an elevated temperature. The metal copper for instance exhibits this behavior. It should be understood that such parasitic conductive paths, i.e. shorts, may also form during the lifetime of an electronic device comprising the silicon substrate wafer 10, which may lead to the failure of the electronic device. It is therefore of crucial importance to ensure that such barrier layer defects are not present in the TSVs 20, 30 of the silicon substrate wafer 10.

To this end, the test arrangement comprising the contact pads 16, 26 and 36 may be used in accordance with an embodiment of a test method of the present invention. A measuring device, which may be arranged to apply a voltage across two terminals or which may be arranged to drive a current from one terminal to the other terminal, is provided. Such measuring devices, which may derive their measurement results from Ohm's law (ΔV = ΔI.R), are well-known and not described in further detail for reasons of brevity only.

For instance, the integrity of the barrier layer 24 may be tested by establishing a conductive contact between one of the terminals of a two-terminal measuring device and the conductive pad 26, and by establishing a conductive contact between the other terminal of the two-terminal measuring device and the conductive pad 16, and by subsequently applying a current or potential between the two terminals, and by measuring the magnitude of the current ΔI or voltage drop ΔV established between the two terminals. Alternatively, the resistance R between the two terminals may be determined.

In case of a defect in the barrier layer 24, a non-negligible current or voltage drop will be measured due to the fact that the resistance of the conductive path between the contact pads 16 and 26 will be only a few ohms rather than reside in the MΩ range, which is indicative of a defect-free barrier layer 24.

Variations to the above method will be immediately apparent to the skilled person. For instance, rather than contacting contact pads 16 and 26, contact pads 26 and 36 may be contacted in case the TSVs 20 and 30 are in relative close proximity to each other and are intended to be electrically insulated from each other. Alternatively, two measurements may be performed to establish the integrity of the barrier layer 24; a first measurement in which the contact pads 16 and 26 are contacted and a second measurement in which the contact pads 26 and 36 are contacted. Such a double measurement can provide additional insights into the integrity of the barrier layer 24; for instance, in case of the first measurement producing an usually large voltage drop and the second measurement producing a normal voltage drop (if any), this is an indication not only of a defective first barrier layer 24 but also of the fact that this defect does not affect the TSV 30, which may for instance be an indication of the integrity of the barrier layer 34.

It is also possible to measure the breakdown voltage of the TSV under test. If this breakdown voltage is determined to fall below a predefined threshold, e.g. 100 V, this is an indication of poor barrier layer integrity. It will be obvious that the aforementioned method steps may be applied to each of the TSVs of the wafer 10 to test the barrier layers of each of these TSVs. However, as soon as a barrier layer defect is found, the test may be terminated because such a result is an indication of a problem in the barrier layer deposition process, after which a destructive evaluation may be applied to the faulty wafer 10, e.g. using SEM or TEM evaluation techniques, to determine the nature of the barrier layer defect. Such information can provide valuable insights in how to improve the barrier layer deposition process.

In a further embodiment, the measurement steps are performed at an elevated temperature, e.g. at or above 100°C, to accelerate the diffusion of metal particles through a defective barrier layer. This improves test sensitivity and reduces test time.

In an embodiment, the TSVs 20 and 30 are dedicated test structures having a square profile that have been added to wafer 10 in addition to the TSVs for providing interconnections in the functional mode of the wafer 10. In other words, the test dedicated TSVs may be considered to form a part of the test arrangement of the wafer 10 of the present invention. The square profile has the advantage that the surface area of the TSVs covered by the barrier layer is increased compared to cylindrical TSVs such that these test TSVs become more sensitive to barrier layer defects.

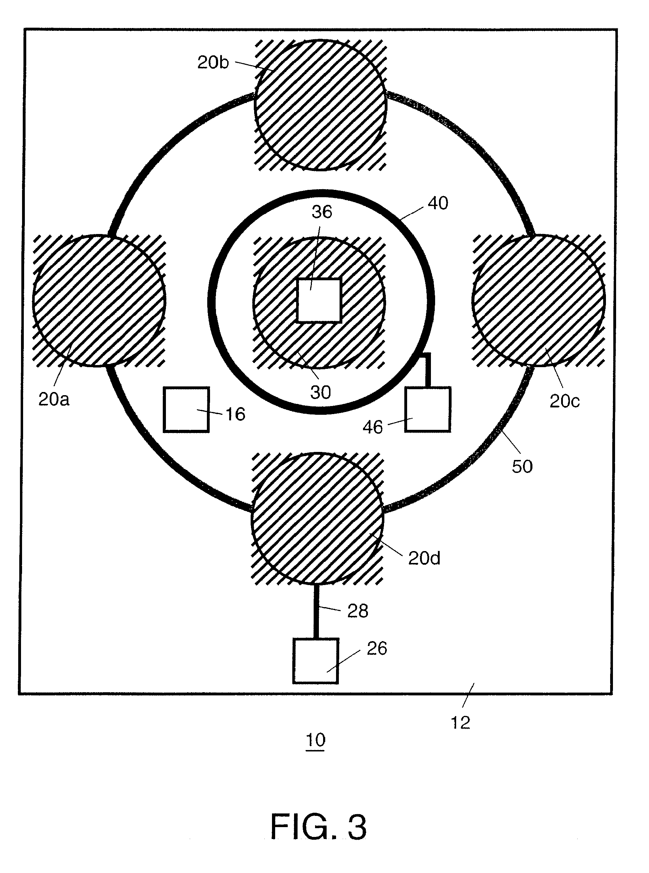

In an alternative embodiment, some of the TSVs may be electrically interconnected through a back side interconnect structure. An example of a silicon substrate wafer 10 in accordance with this embodiment of the present invention is shown in Fig. 3, which depicts a through view of this wafer. The wafer 10 in Fig. 3 comprises four TSVs 20a-20d that are electrically interconnected through a metal routing structure 50 at the back side of the wafer 10 and a TSV 30 that is electrically insulated from the TSVs 20a-d in case the respective barrier layers of these TSVs all exhibit the required integrity. The metal routing structure 50 may be formed using any suitable metallization and patterning process.

The front side of the wafer 10 further comprises a metal pattern 40, e.g. a routing pattern, connected to an additional contact pad 46. Due to the electrical interconnection of the TSVs 20a-20d provided by the back side routing structure 50, only one of the TSVs 20a-20d has to be connected to a contact pad 26. In Fig. 3, TSV 20d is connected to the contact pad 26. The interconnection of the TSVs increases the barrier layer area exposed to an integrity test when the contact pad 26 and a further contact pad, such as the substrate contact pad 16, the contact pad 36 of TSV 30 or the contact pad 46 of the metal pattern 40 on the front side of the wafer 10, are connected to the terminals of the measuring device. Consequently, the interconnection of the TSVs 20a-20d increases the sensitivity of the barrier layer integrity test. Preferably, at least four TSVs are interconnected to achieve a substantial improvement in the sensitivity of the barrier layer integrity test.

In a preferred embodiment, the TSVs 20a-20d and the back side routing structure 50 are test dedicated structures forming a part of the test arrangement of the wafer 10. In this embodiment, the provision of the back side routing structure 50 has the purpose of improving the sensitivity of the test method of the present invention. This has not been disclosed or suggested in the prior art. In fact, such test-dedicated interconnections cannot be achieved in the classical via domain where the backside of the vias are not exposed but buried in the IC.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A silicon substrate wafer (10) comprising:
- a plurality of vias (20, 30) extending from a first surface to a second surface opposite to the first surface of the wafer (10), each via being separated from the silicon substrate by a barrier layer (24, 34); and
- a test arrangement comprising:
- a first contact pad (26) on the first surface, said first contact pad being electrically connected to one of said vias (20); and
- a second contact pad (16, 36, 46) on the first surface, said second contact pad being electrically connected to a wafer portion, said portion being electrically insulated from the via (20) connected to the first contact pad (26) in case the barrier layer of said via (20) is intact.

2. The silicon substrate wafer (10) of claim 1, wherein the via (20) connected to the first contact pad (26) is a dedicated test structure.

3. The silicon substrate wafer (10) of claim 2, wherein the dedicated test structure has a square profile.

4. The silicon substrate wafer (10) of any of claims 1-3, wherein said portion is a silicon substrate portion.

5. The silicon substrate wafer (10) of any of claims 1-3, wherein the second contact pad (36, 46) is connected to a conductive structure, and wherein the test arrangement further comprises a third contact pad (16) electrically connected to a silicon substrate portion.

6. The silicon substrate wafer (10) of any of claims 1-5, wherein some of the vias (20a-20d) are electrically connected through a further conductive structure (50) on the second surface of the wafer.

7. The silicon substrate wafer (10) of claim 6, wherein said electrically connected vias (20a-20d) and the further conductive structure (50) are dedicated test structures.

8. The silicon substrate wafer (10) of claim 6 or 7, wherein the further conductive structure (50) is a metal structure.

9. A method of testing the silicon substrate wafer of any of claims 1-8, comprising:
- providing an electrical measuring device;
- establishing respective conductive contacts between the electrical measuring device and the first contact pad (26) and a first further contact pad (16, 36, 46); and
- measuring an electrical parameter indicative of the integrity of the barrier layer (24) with said measuring device.

10. The method of claim 9, wherein the electrical parameter is the magnitude of a voltage across the first contact pad (26) and the first further contact pad (16, 36, 46).

11. The method of claim 9, wherein the electrical parameter is the magnitude of a current between the first contact pad (16) and the first further contact pad (16, 36, 46).

12. The method of any of claims 9-11, wherein the first further contact pad (16, 36, 46) is the second contact pad.

13. The method of any of claims 9-11, wherein the first further contact pad (16, 36, 46) is the third contact pad.

14. The method of any of claim 9-11, further comprising:
- establishing respective conductive contacts between the electrical measuring device and the first contact pad (26) and a second further contact pad (16, 36, 46); and
- measuring an electrical parameter indicative of the integrity of the barrier layer (24) with said measuring device.

15. The method of any of claims 9-14, wherein the measuring step is performed at an elevated temperature.
